# EUROPEAN PATENT APPLICATION

(11) **EP 4 727 290 A1**
(43) Date of publication of application: **15.04.2026**
(21) Application number: 25207910.8
(22) Date of filing: 10.10.2025
(51) Int. Cl.: H10D 84/05, H10D 30/47, H10D 62/17, H10D 84/80, H10D 84/82, H10D 64/00

(54) **GALLIUM NITRIDE BASED, INTEGRATED, BIDIRECTIONAL SWITCH POWER DEVICE WITH SUBSTRATE-BIASING DIODES**

(30) Priority: 11.10.2024 IT 202400022707
(71) Applicant: STMicroelectronics International N.V., 1228 Plan-les-Ouates, Geneva (CH)
(72) Inventor: CIONI, Marcello, 41011 CAMPOGALLIANO (MO) (IT); CASTAGNA, Maria Eloisa, 95123 CATANIA (IT); IUCOLANO, Ferdinando, 95030 GRAVINA DI CATANIA (CT) (IT); SMERZI, Santo Alessandro, 95127 CATANIA (IT); PIZZARDI, Antonio Filippo Massimo, 95045 MISTERBIANCO (CT) (IT); CONTARINO, Alessandro, 95027 SAN GREGORIO DI CATANIA (CT) (IT)
(74) Representative: Studio Torta S.p.A.

(57) **Abstract**

Integrated bidirectional switch power device (930) based on gallium nitride, comprising a die (40) integrating a first and a second switch FET transistor (31, 32), and a substrate-biasing network (35; 635; 735; 835) configured to electrically couple the substrate node (SUB, 61) selectively to the source region of the first and the second switch FET transistors which is at a lower potential. The substrate-biasing network has a first and second diode (D1, D2) coupled in anti-series and formed by field effect, diode-connected transistors (M1, M2) having the same structure as the first and the second switch FET transistors (31, 32) in the same conduction, contact and gate layers. At least one resistor (R, R1, R2) has a terminal coupled to the substrate node (SUB, 61) and is formed by a resistive portion of the channel layer (43.3), laterally to a channel region (65) in a semiconductor body (41) of the die (40).

## Description

### Technical Field

The present invention relates to a gallium nitride based, integrated, bidirectional switch power device with substrate-biasing diodes.

### Background

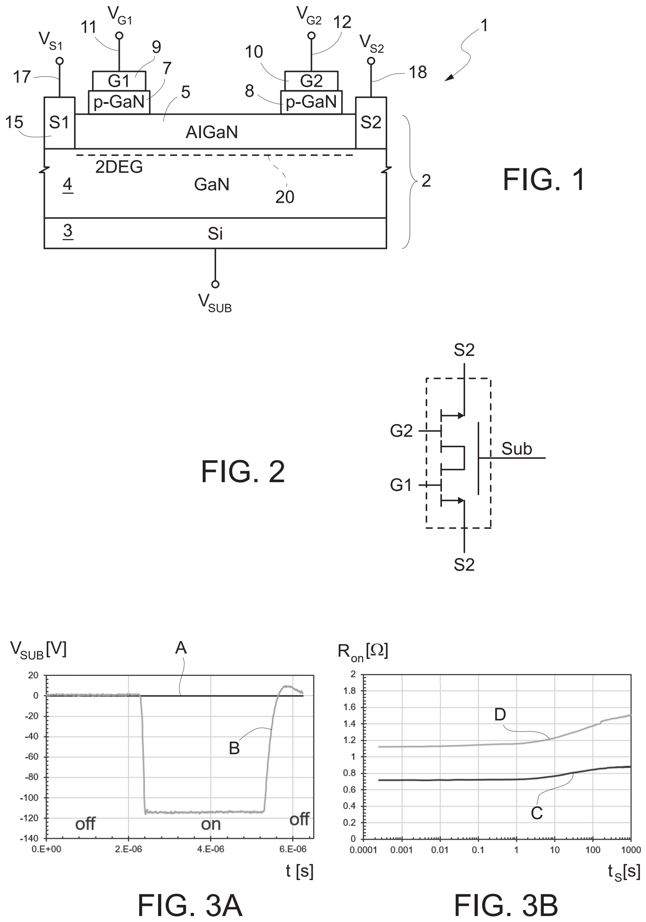

A gallium nitride based bilateral or bidirectional switch power device may be formed as shown in Figure 1 and schematically represented as shown in Figure 2.

In detail, Figure 1 shows a bidirectional switch device 1 comprising a semiconductor body 2, here formed by a substrate 3, a first semiconductor layer 4 and a second semiconductor layer 5, mutually superimposed.

The substrate 3 may be, for example, of monocrystalline silicon; the first semiconductor layer 4, directly superimposed and in contact with the substrate 3, may be of a first semiconductor alloy of elements of groups III and V of the periodic table, for example of gallium nitride (GaN); and the second semiconductor layer 5, directly superimposed and in contact with the first semiconductor layer 4, may be of a second semiconductor alloy, different from the first semiconductor alloy, of elements of groups III and V of the periodic table, for example of aluminum gallium nitride (AlGaN) .

The first semiconductor layer 4 forms, in its upper part, a channel layer, and the second semiconductor layer 5 forms a barrier layer.

The first semiconductor layer 4 and the second semiconductor layer 5 are for example of N-type.

A first gate region 7 and a second gate region 8, of conductive material, extend above the second semiconductor layer 5, at a mutual distance. The first and the second gate regions 7, 8 are for example of a third semiconductor alloy, different from the first and the second semiconductor alloys, of elements of groups III and V of the periodic table, for example of P-type gallium nitride (p-GaN).

Gate electrodes 9, 10 (also indicated in Figure 1 as G1, G2), of metal, are arranged above and in direct electrical contact with the first gate region 7 and the second gate region 8, respectively, and are coupled to a first and, respectively, a second gate terminal 11, 12 configured to provide respective gate voltages V_{G1}, V_{G2}.

The bidirectional switch device 1 further comprises a first and a second source electrode 15, 16 (also indicated in Figure 1 by S1, S2) on and in contact with the first semiconductor layer 4, and are coupled to a first and, respectively, a second source terminal 17, 18.

In the bidirectional switch device 1, the first and the second semiconductor layers 4, 5 form a semiconductive heterostructure that allows a so-called 2-dimensional electron gas (2deg) to be generated, in an electronically controllable manner. A channel region (schematically indicated by 20) is thus formed, and allows a current to flow between the first and second source terminals 17, 18.

In particular, the bidirectional switch device 1 may be controlled in different operating modes, depending on the voltages applied to the gate terminals 11, 12 (ON voltage and OFF voltage), according to the following table 1:

**TABLE 1**

| **V_{G1}** | **V_{G2}** | **Mode** |
|---|---|---|
| OFF | OFF | Switch OFF |
| ON | ON | Switch ON |
| ON | OFF | Diode |
| OFF | ON | Diode |

For example, the OFF voltage may be equal to 0 V and the ON voltage may be equal to 6 V.

Furthermore, depending on the voltages applied to the source terminals 17, 18, currents may flow from the first source electrode 15 towards the second source electrode 16 or in the opposite direction. Consequently, in case of switching operation, each time, one of the two source terminals 17, 18 operates as a drain terminal (at a higher voltage) and the other of the two source terminals 17, 18 operates as a source terminal (at a lower voltage).

Furthermore, the bidirectional switch device 1 may operate as a diode. In this case, a same voltage is applied to one of the gate terminals 11, 12 and to the adjacent source terminal 17, 18. Consequently, each time, one of the two source terminals 17, 18 operates as an anode terminal and the other of the two source terminals 17, 18 operates as a cathode terminal.

In the bidirectional switch device 1, the voltage of the substrate 3 (indicated by V_{SUB} in Figure 1) is critical as it may negatively influence the operation of the bidirectional switch device 1, in particular during switching operation.

In particular, V_{SUB} which, in unilateral devices, is clamped to the minimum voltage in the device (typically the source voltage) here cannot be clamped to the voltage present on one of the source terminals, since, as mentioned, each source terminal S1, S2 may work (even in an alternate manner) at a higher voltage than the other source terminal S1, S2.

On the other hand, the substrate 3 cannot be left floating, because in this case a "back gating" phenomenon may occur where the substrate 3 is at an intermediate voltage between the source voltages Vs1, Vs2 and behaves as an additional gate region, causing an imbalance between the voltages present on the device, a depletion of the 2-dimensional electron gas and the reduction of the conduction of the bidirectional switch device 1.

These situations are shown in Figure 3A, relating to the substrate voltage V_{SUB} in case of substrate 3 coupled to ground (i.e. to the potential of the terminal at the lower potential, here to the source terminal 17, line A) and of substrate 3 left floating (line B), in switching operation condition with voltage on the source terminals 17, 18 switching between 0 V and 200 V.

Figure 3B shows the corresponding trend of the on-resistance Ron, as a function of the stress time tₛ where line C refers to the case of substrate 3 coupled to ground and line D refers to the case of substrate 3 left floating.

To solve this problem, external circuits may be used that couple the substrate 3 to the voltage which is each time lower in the device. However, even these solutions do not satisfactorily solve the problem, both because of their complexity and as they are not able to ensure the desired speed and synchronization.

US 2014/0374766A1 and EP 3447917 describe automatic bias circuits of the substrate of gallium nitride based bidirectional switches using diodes. The diodes may be external or integrated in the same die, using different topologies, but they do not always have suitable electrical features (switching times, voltage withstanding) for the desired performances.

US 2019/006499A1, US 2013/062614A1 and US 2022/093584A1 disclose different bidirectional switch power devices having substrate voltage management circuits including field effect transistors.

The aim of the present invention is to provide a solution that overcomes the drawbacks of the prior art.

### Summary

According to the present invention, a gallium nitride based, integrated, bidirectional switch power device is provided, as defined in the attached claims.

### Brief Description of the Drawings

For a better understanding of the present invention, embodiments thereof are now described, purely by way of nonlimiting example, with reference to the attached drawings, wherein:
- Figure 1 is a schematic cross-section of a known gallium nitride based bidirectional switch;
- Figure 2 is an electrical equivalent of the bidirectional switch of Figure 1;
- Figures 3A and 3B show the plots of electrical quantities of the bidirectional switch of Figure 1;
- Figure 4 is a simplified electrical diagram of an embodiment of the present bidirectional power switch;
- Figure 5 shows the plots of electrical quantities of the bidirectional power switch of Figure 4;
- Figures 6-8 show simplified electrical diagrams of other bidirectional power switches, according to the present disclosure;
- Figure 9 shows the layout of a semiconductor die integrating a bidirectional power switch, according to a first configuration;
- Figure 10 shows the layout of a semiconductor die integrating a bidirectional power switch, according to another configuration;
- Figure 11 is a cross-section of a part of the die of Figure 9 or 10, taken basically along line XI-XI of Figure 9;
- Figures 12A, 12B and 12C show the simplified layout of metal layers in the semiconductor die of Figure 9 or Figure 10;
- Figure 13 is a cross-section, on an enlarged scale, of a possible implementation of a resistor using a gallium nitride based technology;
- Figure 14 is cross-section, on an enlarged scale, of a possible implementation of the resistor of Figure 13, taken along line XIV-XIV of Figure 9;
- Figure 15 shows, on an enlarged scale, a detail of the structure of Figure 14;
- Figure 16 is a cross-section of a part of the die of Figure 9 or Figure 10, similar to Figure 11, in case of a bidirectional switch formed as shown in the electric diagram of Figure 7;
- Figure 17 is a plan view of a portion of the bidirectional switch of Figure 16, of the source-gate connection of a diode;
- Figure 18 is a longitudinal section, on an enlarged scale, taken along line XVIII-XVIII of Figure 17;
- Figure 19 is schematic plan view, on a reduced scale, of a part of the first metallization layer of the bidirectional switch of Figure 16;
- Figure 20 is a cross-section of a part of the die of Figure 9, similar to Figure 16, in case of a bidirectional switch formed as shown in the electric diagram of Figure 8;
- Figure 21 is a plan view, on an enlarged scale, of a portion of the bidirectional switch of Figure 20, of the source-gate connection of a diode;
- Figure 22 is a longitudinal section, taken along line XXII-XXII of Figure 21;
- Figure 23 is a perspective view of a possible coupling of the die of Figure 9 or Figure 10 to a leadframe and of its package; and
- Figure 24 is a plan view of the die of Figure 9 or Figure 10 coupled to the leadframe of Figure 23.

### Description of Embodiments

The following description refers to the arrangement shown; consequently, expressions such as "above", "below", "upper", "lower", "right", "left" relate to the attached Figures and are not to be interpreted in a limiting manner.

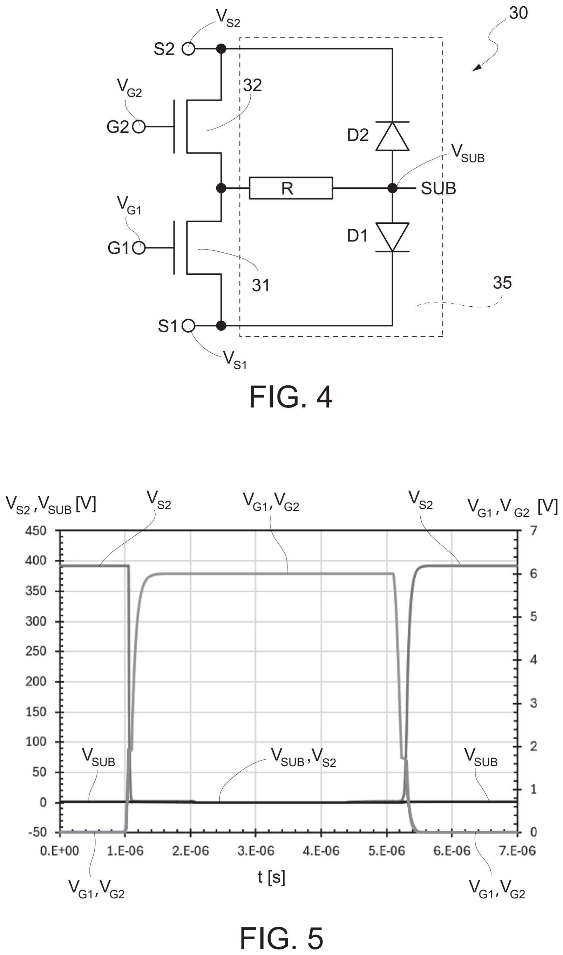

Figure 4 shows the electrical diagram of a bidirectional switch power device 30, based on gallium nitride, integrating a self-biasing network of the substrate, such as to maintain the substrate clamped to the device voltage which is each time the lowest during operation, also in case of switching operation.

The bidirectional switch power device 30 is schematically represented as the series-connection of a first and a second field effect transistor (FET) 31, 32, coupled between a first conduction terminal S1 and a second conduction terminal S2.

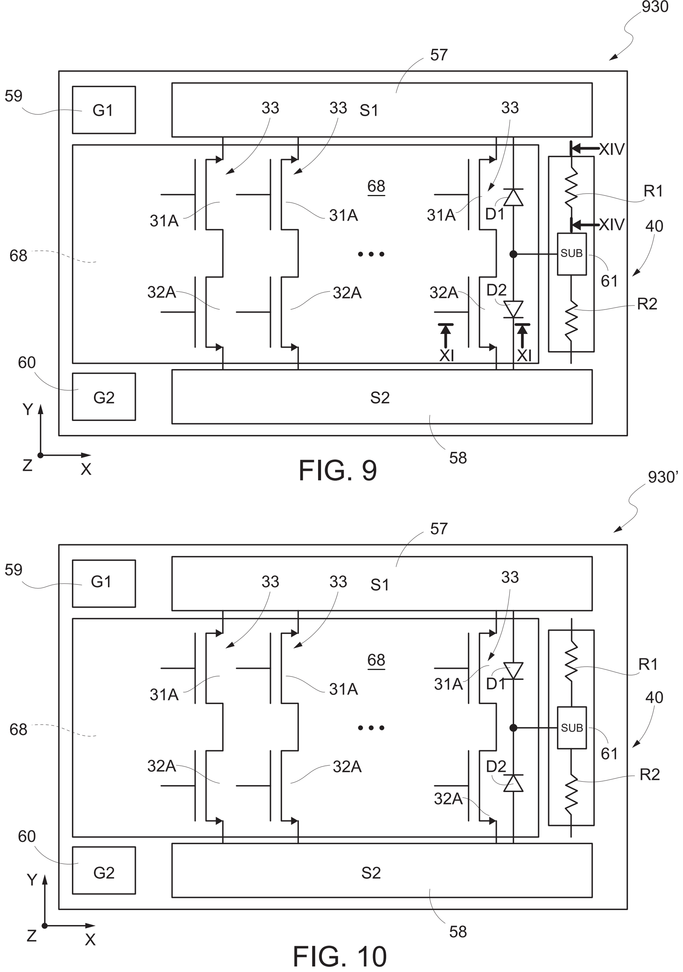

The first and the second FET transistors 31, 32 have a structure that is schematically representable as shown in Figure 1 and described above; in particular, they are implemented as described below with reference to Figures 9, 10.

The bidirectional switch power device 30 has a first gate terminal G1 and a second gate terminal G2, configured to receive respective gate voltages V_{G1}, V_{G2}.

The first and the second FET transistors 31, 32 are also mutually coupled in a common node indicated by D.

The conduction terminals S1, S2 and the gate terminals G1, G2 are intended to be connected to the outside of the bidirectional switch power device 30 through suitable leads, as described in detail below.

The first and the second conduction terminals S1, S2 are also coupled to a substrate node SUB through a substrate-biasing network 35. The substrate node SUB is generally not accessible from the outside, but, if useful, may be connected externally.

The substrate-biasing network 35 here comprises a first diode D1, having a cathode coupled to the first conduction terminal S1 and an anode coupled to the substrate node SUB; a second diode D2, having a cathode coupled to the second conduction terminal S2 and an anode coupled to the substrate node SUB; and a resistor R, coupled between the common node D and the substrate node SUB.

The first and the second diodes D1, D2 are therefore coupled in common-anode configuration.

The first and the second diodes D1, D2 are implemented as field effect transistors using a gallium nitride technology, and have the structure of the first and the second FET transistors 31, 32, as described in detail below.

The bidirectional switch power device 30 operates as follows (see also Figure 5), assuming that the first and the second gate terminals G1, G2 are controlled together, switching them between an ON voltage and an OFF voltage. Alternatively, the second gate terminal G2 may be coupled to the second conduction terminal S2. In this second case the second FET 32 is diode-connected. In this case, the reverse conduction (third quadrant) of the diode-connected transistor is exploited.

In a first operating condition, a first biasing voltage V_{S1} is applied to the first conduction terminal S1 and a second biasing voltage V_{S2}, greater than the first biasing voltage V_{S1}, is applied to the second conduction terminal S2. In this case, the first biasing voltage V_{S1} is a reference voltage (e.g. ground) and the second biasing voltage V_{S2} is high. The bidirectional switch power device 30 is controlled by applying an ON or OFF voltage to the first and the second gate terminals G1, G2 (or only to the first gate terminal G1) (Figure 5), so as to switch it on or off (respectively, in an "ON" phase and in an "OFF" phase).

For example, in the switching operation shown in Figure 5, in the OFF phase, the first and the second gate terminals G1, G2 are coupled to ground and, in the ON phase, are brought to a switching-on voltage, for example greater than 6 V; and the second biasing voltage V_{S2} is at a high value (for example 400 V).

In the OFF phase, the gate terminals G1, G2 block the current flow through the bidirectional switch power device 30; in the ON phase, the bidirectional switch power device 30 switches on and the FETs enter a linear zone, causing a current to flow from the second conduction terminal S2 toward the first conduction terminal S1. In this ON phase, the voltage V_{S2} on the second conduction terminal S2 decreases and almost reaches voltage V_{S1} on the first conduction terminal S1 (ground).

In a second operating condition, the biasing of the source terminals S1, S2 (and possibly of the gate terminals G1, G2, in case of diode-connection) is inverted with respect to the first operating condition, so that, in the on phase, a current may flow from the first conduction terminal S1 toward the second conduction terminal S2.

In the first operating condition, the second diode D2 is reverse biased and therefore open; in the ON phase, the first diode D1 is on and clamps the substrate voltage V_{SUB} to the voltage of the first conduction terminal S1 (V_{S1}, to ground). In the OFF phase, the substrate voltage V_{SUB} remains low. In this phase, resistor R (which has high resistance, for example of a few MΩ) conducts a very low, negligible current, while common node D is coupled to the potential of the second source terminal S2, in the first operating condition, and to the first source terminal S1, in the12one12dd operating condition.

In dual mode, in the second operating condition, the first diode D1 is open; in the ON phase, the second diode D2 is on and clamps the substrate voltage V_{SUB} to the voltage V_{S2} of the second conduction terminal S2 (to ground). In the OFF phase, the substrate node SUB remains to ground.

In practice, the substrate-biasing network 35 forms a sub-bias control block that clamps the substrate node SUB to the conduction terminal S1, S2 which is, each time, at the lowest voltage.

Furthermore, the substrate-biasing network 35 maintains the substrate node SUB clamped to ground both in the ON phase and in the OFF phase, preventing undesired transients.

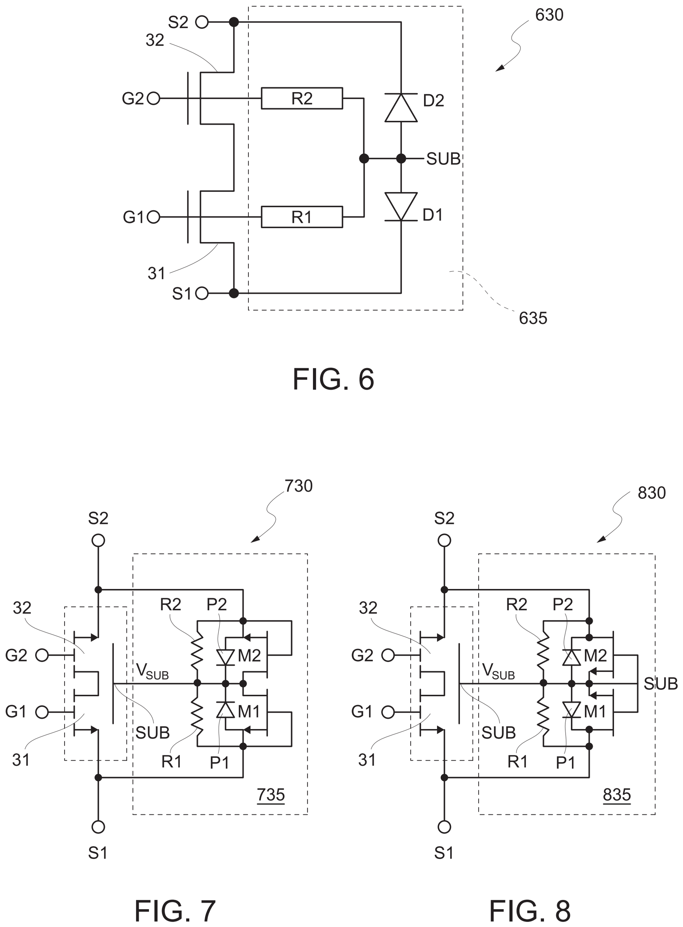

Figure 6 shows a bidirectional switch power device 630 comprising a first and a second FET transistor similar to those of the bidirectional switch power device 30 of Figure 4 and therefore indicated again by 31, 32.

Furthermore, the bidirectional switch power device 630 comprises a substrate-biasing network 635 including a first and a second diode formed and coupled as the bidirectional switch power device 30 of Figure 4 and therefore indicated again by D1, D2.

The substrate-biasing network 635 here comprises a first resistor R1 coupled between the substrate node SUB and the first gate terminal G1 and a second resistor R2 coupled between the substrate node SUB and the second gate terminal G2.

Figure 7 shows a bidirectional switch power device 730 comprising a first and a second FET transistor similar to the transistors of the bidirectional switch power device 30 of Figure 4 and therefore indicated again by 31, 32.

Furthermore, the bidirectional switch power device 730 comprises a substrate-biasing network 735 including a first bias transistor M1, a second bias transistor M2, a first resistor R1 and a second resistor R2.

The bias transistors M1, M2 are diode-coupled between a respective conduction terminal S1, S2 and the substrate node SUB and therefore form two diodes similar to the diodes D1 and D2 of Figure 4.

In detail, the first bias transistor M1 is coupled with its source and gate terminals to the first conduction terminal S1 and with its drain terminal to the substrate node SUB.

The second bias transistor M2 is coupled with its source and gate terminals to the second conduction terminal S2 and with its drain terminal to the substrate node SUB.

In practice, the substrate-biasing network 735 provides a common-drain coupling of the bias transistors M1, M2; since the bias transistors M1, M2 are diode-coupled, this configuration is hereinafter also referred to as a common-anode configuration.

In Figure 7, the first resistor R1 is coupled between the first conduction terminal S1 and the substrate node SUB.

The second resistor R2 is coupled between the second conduction terminal S2 and the substrate node SUB.

The bias transistors M1, M2 are integrated in a same semiconductor die with the FET transistors 31, 32, at the side thereof; furthermore, they are made using the same technology and have the same structure as the FET transistors 31, 32, as described in detail below with reference to Figures 9-11.

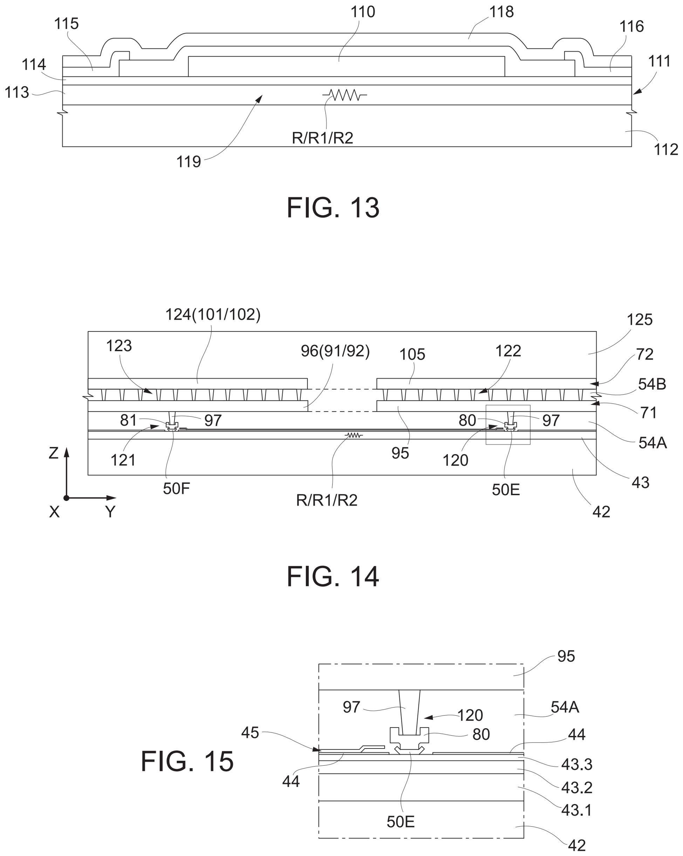

The first and the second resistors R1, R2 are also made using the same technology and the same layers as the FET transistors 31, 32 and the bias transistors M1, M2, at the side thereof, as described in detail below with reference to Figures 13-15.

In Figure 7 parasitic diodes P1, P2 are also shown formed by the bias transistors M1, M2, in antiparallel with respect to the diode coupling of the latter.

Figure 8 shows a bidirectional switch power device 830 similar to the bidirectional switch power device 730 of Figure 7, except that the bias transistors M1, M2 of the substrate-biasing network, here indicated by 835, are arranged in a common-source configuration, hereinafter also referred to as a common-cathode configuration.

The components of the bidirectional switch power device 830 equal to the components of the bilateral switch power device 730 are therefore indicated by the same reference numbers.

The bidirectional switch power devices 630, 730 and 830 operate in a similar manner to what has been described for the bidirectional switch power device 30 of Figure 4.

In particular, the bias transistors M1, M2 that are diode-connected and anti-series coupled, common-anode or common-cathode transistors, provide current paths from the substrate node SUB towards the conduction terminal S1, S2 which is each time at the lower voltage through the respective parasitic diodes P1, P2, intrinsically present in the GaN-HEMT technology.

The resistors R, R1, R2 are discharge paths for the charges stored due to capacitive effect in the substrate of the die wherein the bidirectional switch power devices 630, 730 and 830 are integrated.

In this manner, the substrate-biasing networks 35, 635, 735, 835 provide reliable and effective control of the substrate potential.

Forming all components using the GaN-HEMT technology allows the required area to be reduced and the performances to be improved, with reduced manufacturing cost.

Figures 9-11 show possible solutions for the integration of a generic bidirectional switch power device, here indicated by 930, valid for all bidirectional switch power devices 30, 630, 730, 830, by suitably connecting the diodes D1, D2 and the resistors R, R1, R2.

In particular, Figure 9 shows the layout of the bidirectional switch power device 930 in the case of diodes D1, D2 with anode coupling, usable in general for the embodiments of Figures 4, 6 and 8, depending on the connections of the resistor or resistors R, R1, R2 to the FET transistors 30, 31 and Figure 10 shows the layout of the bidirectional switch power device 930 in the case of diodes D1, D2 with coupled cathodes, usable in general for the embodiment of Figure 8, but also usable for the configurations of Figures 4 and 6 with opposite coupling of the diodes D1, D2, suitably forming the connections of the resistor or resistors R, R1, R2 to the FET transistors 30, 31.

For this reason, in Figures 9 and 10 the connections of the resistor or resistors R, R1, R2 are not represented, but are obvious to the person skilled in the art, also on the basis of the following description of the embodiments of the bidirectional switch power devices 730, 830).

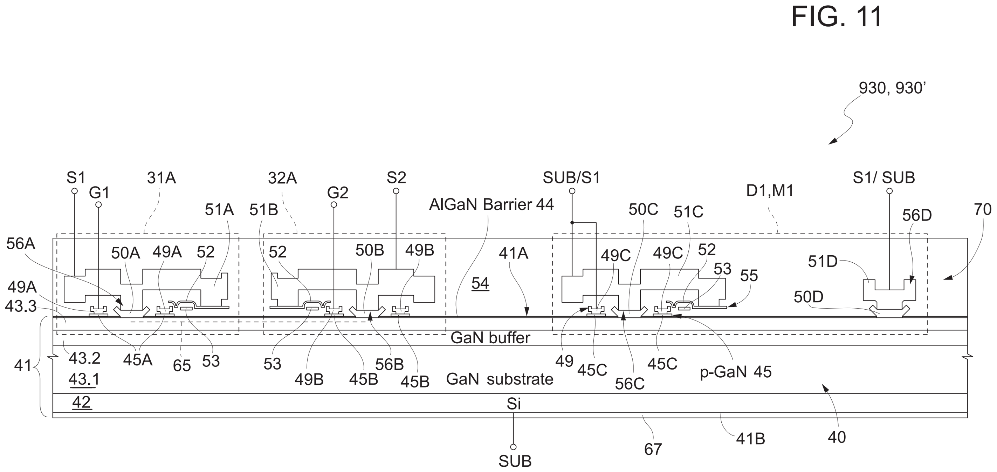

In detail, with reference to Figures 9 and 11, the bidirectional switch power device 930 (hereinafter also simply called device 930) is integrated into a die 40 of which Figure 9 shows the layout in an XY plane of a Cartesian coordinate system XYZ having a first horizontal axis X, a second horizontal axis Y and a vertical axis Z and Figure 11 shows a cross-section taken in an XZ plane of the Cartesian coordinate system XYZ.

Figure 9 schematically shows an active region 68 where the FET transistors 31, 32 and the diodes D1, D2 are formed.

In the considered embodiment, the first FET transistor 31 is formed by a plurality of first power elements 31A, adjacent to each other; the second FET transistor 32 is formed by a plurality of second power elements 32A, adjacent to each other. Each first power element 31A is coupled in series to a respective second power element 32A, forming an elementary branch 33; the elementary branches 33 are coupled in parallel to each other.

Furthermore, each first power element 31A is integrated adjacent to a second power element 32A, as visible in Figure 11, which shows the integration of a single first power element 31A and a single second power element 32A of a same elementary branch 33.

The diodes D1, D2 are arranged in proximity to one side of the active region 68, at the side of the FET transistors 31, 32, preferably integrated so as to extend one to the side of the other.

Figure 9 also shows the position of the resistors R1, R2 (possibly parallel-connected to form the single resistor R of the bidirectional switch power device 30 of Figure 4), laterally to the active region 68, here laterally to the diodes D1, D2.

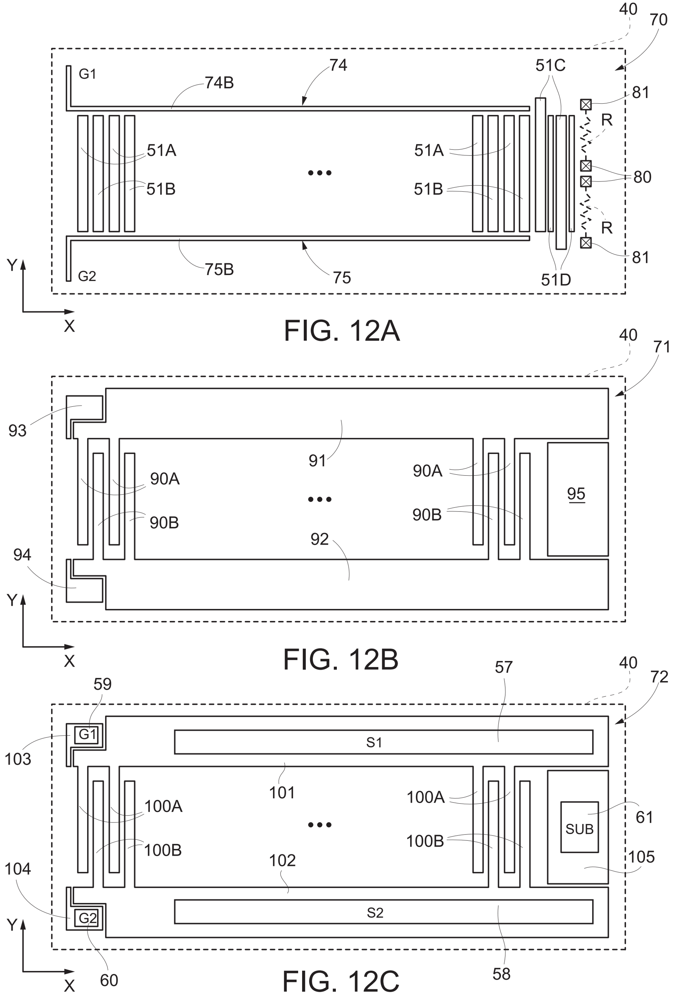

Figure 9 also schematically shows a possible arrangement of the pads of the conduction terminals S1, S2 (source pads 57, 58), of the gate terminals G1, G2 (gate pads 59, 60) and of the substrate node SUB (substrate pad 61), formed in an upper metallization level, as described in detail below with reference to Figure 12C.

A possible integration of the FET transistors 31, 32 and the diodes D1, D2 in the die 40 will be described hereinafter with reference to Figure 11.

In particular, Figure 11 shows the integration of a single first power element 31A, a single second power element 32A, and a single diode, for example the first diode D1; the other diode (second diode D2) that, as indicated above, may be arranged at the side of the first diode D1, has an identical structure.

Here, the first diode D1 (like the second diode D2, not shown) is a transistor (indicated by M1, by analogy to Figures 7 and 8), made using the same technology and having the same structure as the first and the second power elements 31A, 32A, wherein the source and gate regions are electrically connected using two metallization levels already present for the FET transistors 31, 32, as explained below.

The die 40 comprises a semiconductor body 41 having an upper surface 41A and a lower surface 41B, and including, in the embodiment shown, a substrate 42, a first semiconductor layer 43, a second semiconductor layer 44 and a third conductive layer 45, mutually superimposed in the direction of the vertical axis Z.

The substrate 42 may be, for example, of monocrystalline silicon.

The first semiconductor layer 43, directly superimposed and in contact with the substrate 42, may be composed of a series of sub-layers formed by different alloys of elements of groups III and V of the periodic table, including gallium nitride (GaN) .

In particular, in Figure 11, the first semiconductor layer 43 comprises a first sub-layer 43.1 formed by different combinations of AlGaN/GaN/AlN alloys; a second sub-layer 43.2, of GaN, forming a buffer layer; and a third sub-layer 43.3, of GaN, forming a channel layer.

The second semiconductor layer 44, directly superimposed and in contact with the first semiconductor layer 43, may be of a different semiconductor alloy of elements of groups III and V of the periodic table, for example of aluminum gallium nitride (AlGaN), and forms a barrier layer.

The first semiconductor layer 43 and the second semiconductor layer 44 are for example N-type.

The third semiconductor layer 45 is of a further semiconductor alloy of elements of groups III and V of the periodic table, typically different from the alloys of the first and the second semiconductor layers 43, 44. The third semiconductor layer 45 is for example of P-type gallium nitride (p-GaN) and forms a plurality of gate conductive regions which extend, at a mutual distance, above the second semiconductor layer 44, in a direction parallel to the second horizontal axis Y. Hereinafter, therefore, the third semiconductor layer 45 is also referred to as gate layer 45.

In particular, Figure 11 shows a first gate conductive region 45A, a second gate conductive region 45B, and a third gate conductive region 45C, belonging to the first power element 31A, the second power element 31B, and the diode D1, respectively. In the cross-section of Figure 11, each gate conductive region 45A-45C is divided into two parts.

A first, a second, and a third gate metallization region 49A, 49B, and 49C, belonging to a gate metallization level 49, are in direct contact with the first gate conductive region 45A, the second gate conductive region 45B, and the third gate conductive region 45C, respectively.

In particular, the first and the second gate metallization regions 49A and 49B are coupled to the first and, respectively, the second gate terminal G1, G2 and the third gate metallization region 49C is coupled to the lower cathode contact region 56C.

In particular, and in a manner not shown, the first and the second gate metallization regions 49A and 49B are formed by strips extending perpendicularly to the plane of the sheet, here parallel to the second horizontal axis Y, forming "gate fingers".

As discussed below, the gate metallization regions 49A, 49B are coupled at their ends, in a manner not represented, to gate contact regions formed in the same layer as the lower conduction contact portions 51A, 51B, 51C, 51D, as described below with reference to Figure 12A.

The bidirectional switch power device 930 also comprises ohmic contact regions to obtain a low resistivity contact between the conduction terminals S1, S2 and the first semiconductor layer 43, and between the substrate node SUB and the first semiconductor layer 43.

In detail, Figure 11 shows a first ohmic contact region 50A belonging to the first power element 31A; a second ohmic contact region 50B belonging to the second power element 31B, a third and a fourth ohmic contact region 50C, 50D belonging to the diode D1.

The ohmic contact regions 50A, 50B, 50C and 50D are in direct electrical contact with the first semiconductor layer 43 of the semiconductor body 41 (and more precisely with the channel layer 43.3) and are for example formed by a Ti/AlCu/TiN multilayer.

The channel layer 43.3 forms, between the first and the second ohmic contact regions 50A, 50B, a channel region, schematically indicated by 65.

The ohmic contact regions 50A, 50B, 50C and 50D are part of conduction contact structures further including a first, a second, a third and a fourth conduction metallization regions 51A, 51B, 51C and 51D, superimposed and in direct electrical contact with the first, second, third and fourth ohmic contact regions 50A, 50B, 50C and 50D, respectively.

In particular, the first, the second, the third and the fourth ohmic contact regions 50A, 50B, 50C and 50D (together with the respective conduction metallization regions 51A, 51B, 51C and 51D) form respective lower source contact portions of the first and the second power elements 31A, 31B and lower source and drain contact portions of the transistor M1 (that forms the first diode D1). Therefore, hereinafter they are also referred to as first lower transistor source contact region 56A, second lower transistor source contact region 56B, lower cathode contact region 56C and lower anode contact region 56D.

The conduction metallization regions 51A, 51B, 51C and 51D are formed in a metal layer, called first interconnection metallization level 70, shown in Figure 12A. Conduction metallization regions 51A, 51B, 51C and, possibly, 51D are shaped to also form field plates. In the embodiment shown in Figure 11, the conduction metallization regions 51A, 51B, 51C are also in direct electrical contact with field plate structures comprising thin metal regions 52, formed in a thin metal layer 55 (also called level 0), and auxiliary metal regions 53, formed in the same layer as the gate metallization regions 49A-49C (gate metallization level 49). The field plate structures 52-53 may be present on both sides of the conduction metallization regions 51A, 51B, 51C or be entirely missing.

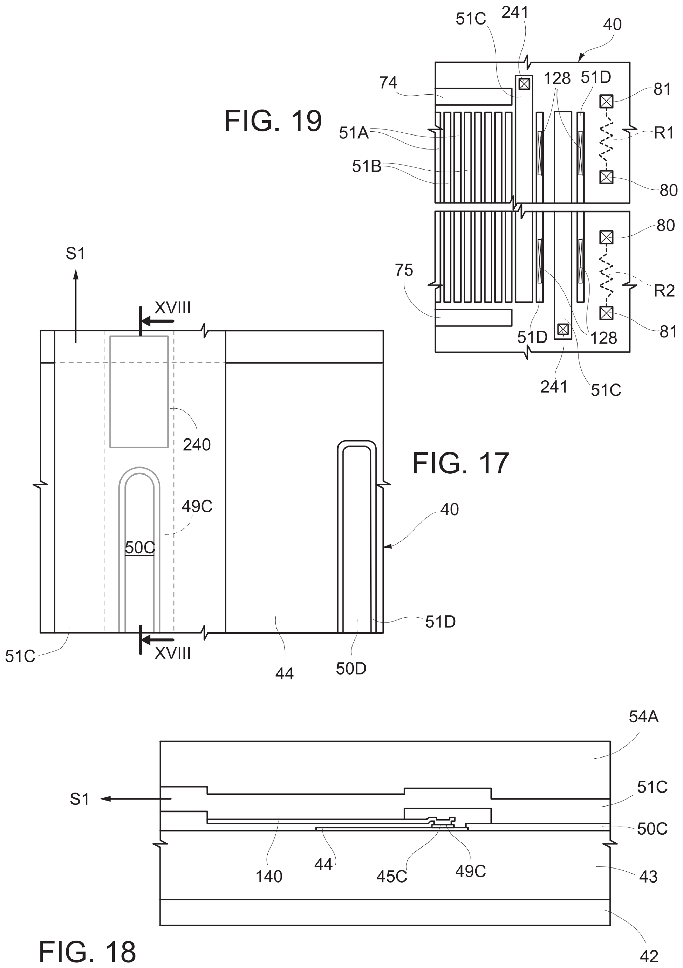

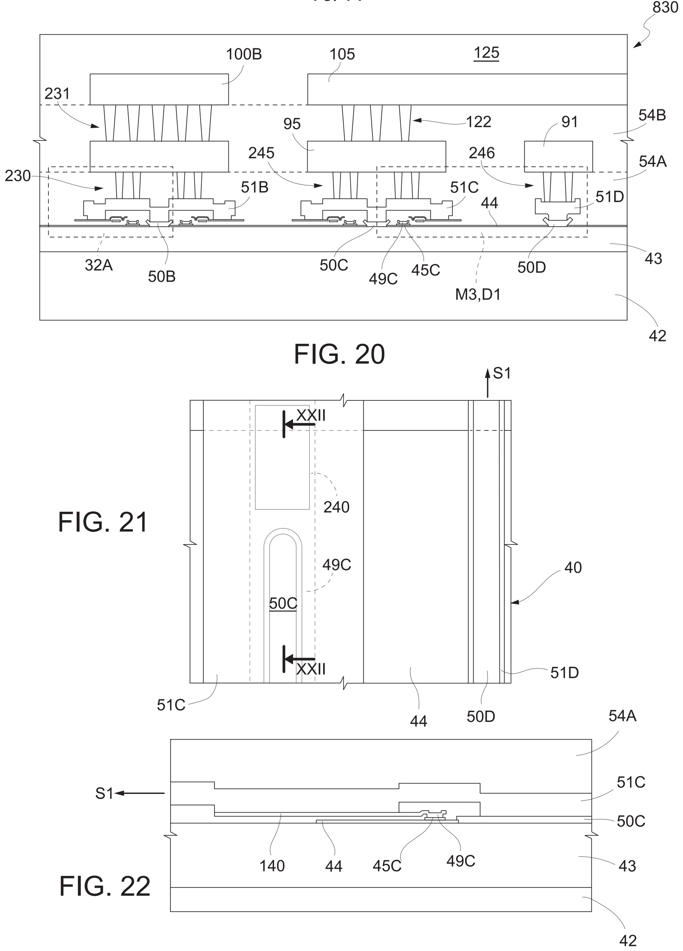

As schematically represented in Figure 11 and described in detail with reference to Figures 17, 18 for the bidirectional switch power device 730 of Figure 7 and in Figures 21, 22 for the bidirectional switch power device 830 of Figure 8, the third lower conduction contact portion 51C of the first interconnection metallization level 70 is electrically coupled to the third gate metallization region 49C, forming the diode D1. In this manner, the third ohmic contact region 50C (source contact of the first bias transistor M1) forms a cathode terminal of the diode D1 and the fourth ohmic contact region 50D (drain contact of the first bias transistor M1) forms an anode terminal of the diode D1.

An insulating layer, generally indicated by 54 and generally formed by a plurality of superimposed insulating layers, for example of silicon oxide, covers the upper surface 41A of the semiconductor body 41 and embeds the gate conductive regions 45A-45C, the gate metallization regions 49A-49C, the ohmic contact regions 50A-50D, the lower conduction contact portions 51A-51D and the field plate structures 52-53.

Vias (not shown) extend through the insulating layer 54 and couple the lower conduction contact portions 51A-51D to upper metallization levels allowing connection with external terminals and formation of connections of the device 930, as discussed in detail below for the bidirectional switch power devices 730 and 830 of Figures 7, 8.

In particular, as schematically shown in Figure 11, the first conduction metallization region 51A is coupled to the first conduction terminal S1; the second metallization region 51B is coupled to the second conduction terminal S2; the third metallization region 51C is coupled to the third gate conductive region 45C and to one of the first conduction terminal S1 and the substrate node SUB (depending on whether the device 930 forms the bidirectional switch power device 30, 630, 730, or 830); and the fourth metallization region 51D is coupled to the other of the first conduction terminal S1 and the substrate node SUB.

A rear metallization layer 67, coupled to the substrate node SUB extends on the lower surface 41B of the semiconductor body 41, as described in detail below.

The die 40 also accommodates, at the side of the diodes D1, D2, the resistors R, R1, R2, not shown in Figure 11 and described in detail below with reference to Figures 12-14.

Figure 10 shows the layout of the bidirectional switch power device (here indicated by 930') in case of cathode-coupled diodes D1, D2. This layout is entirely similar to that of Figure 9 and what has been described above with reference to Figures 9 and 11 is also applicable to the configuration of Figure 10, except for the connection of the two diodes D1, D2 to each other at the cathode terminals, instead of the anode terminals (not visible in Figure 11), and the connection between the conduction terminals S1, S2 and the anode and cathode terminals, which are mutually exchanged.

The components of the device 930, 930' shown in Figures 9-11 are interconnected to each other using three interconnection metallization levels superimposed on the gate metallization level 49 and level 0 (thin metal layer 55), visible in Figure 11.

In detail, the device 930, 930' comprises three interconnection metallization levels, which have a similar configuration for the device 930 of Figure 9 and for the device 930' of Figure 10 and differ substantially only in the interconnections between the different levels.

The three metallization levels are then shown for both devices 930, 930' in Figures 12A-12C and comprise the first interconnection metallization level 70 (also visible in Figure 11 and shown in detail in Figure 12A); a second interconnection metallization level 71 (not visible in Figure 11 and shown in detail in Figure 12B); and a third interconnection metallization level 72 (not visible in Figure 11 and shown in detail in Figure 12C).

In particular, in the embodiment shown in Figure 12A, the first interconnection metallization level 70, formed above the thin metal layer 55, comprises:
a first lower gate contact portion 74;
a second lower gate contact portion 75;
a plurality of first conduction metallization regions 51A (one whereof shown in Figure 11);
a plurality of second conduction metallization regions 51B (one whereof shown in Figure 11);
two third conduction metallization regions 51C; and
two fourth conduction metallization regions 51D.

The first lower gate contact portion 74 comprises a first lower gate metal connection portion 74A and a first longitudinal portion 74B.

The second lower gate contact portion 75 comprises a second lower gate metal connection portion 75A and a second longitudinal portion 75B.

The first and the second lower gate metal connection portions 74A, 75A allow connection with the second interconnection metallization level 71, through vias not shown, to form the first gate terminal G1 and the second gate terminal G2, respectively.

The first and the second longitudinal portions 74B, 75B have an elongated shape (here in a direction parallel to the first horizontal axis X) and are coupled with the first and, respectively, the second gate metallization regions 49A, 49B in the gate metallization level 49 of Figure 11, through vias not shown.

The first and the second conduction metallization regions 51A, 51B have here an elongated shape in a direction parallel to the second horizontal axis Y, and extend between the longitudinal portions 74B, 75B (but are electrically insulated therefrom).

The first and the second conduction metallization regions 51A, 51B essentially form source fingers, interdigitated with each other.

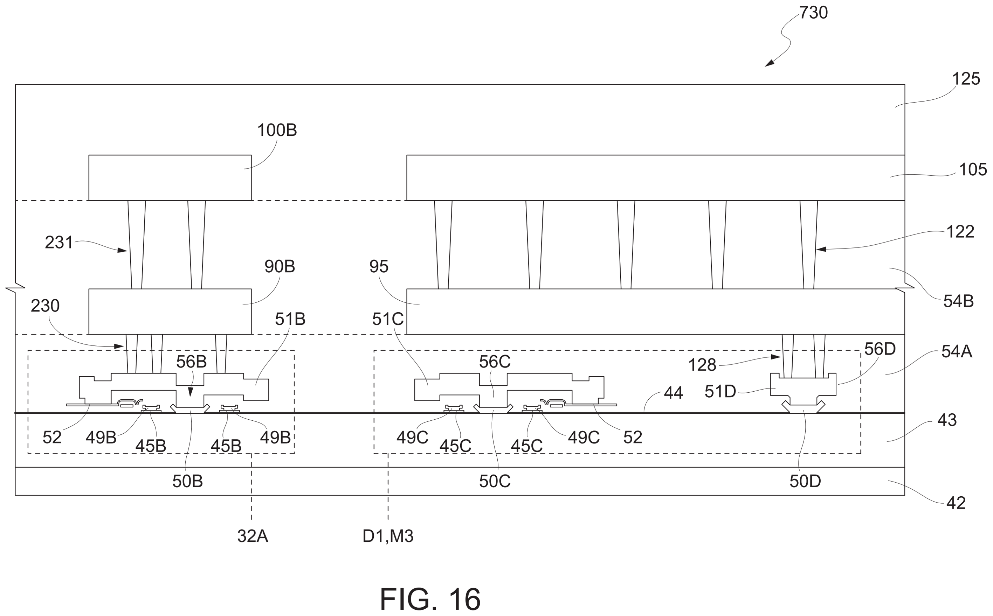

Each third conduction metallization region 51C is adjacent to a respective fourth conduction metallization region 51D; the third and the fourth conduction metallization regions 51C, 51D have an elongated shape, extend parallel and approximately with the same length as the first and the second lower conduction contact portions 51A, 51B, laterally thereto, and are connected to the second interconnection metallization level 71 in the manner shown and described in detail below with reference to Figures 16 and 20 for forming the coupled anode or cathode configuration.

Furthermore, here, the first interconnection level forms contact metal portions 80, 81 for the resistors R, R1, R2 (schematically represented); such contact metal portions 80, 81 are described in detail hereinbelow with reference to Figures 13-15.

Figure 12B shows an example layout of the second interconnection metallization level 71.

In detail, in Figure 12B, the second interconnection metallization level 71 forms:
a first intermediate gate contact portion 93, coupled to the first lower gate contact portion 74A through lower gate intermetal connections (e.g., vias) not shown;
a second intermediate gate contact portion 94, coupled to the second lower gate contact portion 75A through vias not shown;
a plurality of first intermediate conduction contact portions 90A, each first intermediate conduction contact portion 90A overlying a respective first lower conduction contact portion 51A and in electrical contact therewith through vias not shown;
a plurality of second intermediate conduction contact portions 90B, each second intermediate conduction contact portion 90B overlying a respective second lower conduction contact portion 51B and in electrical contact therewith through vias not shown;
a third intermediate conduction contact portion 91, extending transverse to the first intermediate conduction contact portions 90A and in electrical contact therewith at one end thereof. Here, the third intermediate conduction contact portion 91 extends for example in a direction parallel to the first horizontal axis X;
a fourth intermediate conduction contact portion 92, extending transverse to the second intermediate conduction contact portions 90B and in electrical contact therewith at one end thereof. Here, the fourth intermediate conduction contact portion 92 extends for example in a direction parallel to the first horizontal axis X; and
an intermediate substrate contact portion 95 selectively coupled to the third or the fourth lower conduction contact portion 51C, 51D depending on the configuration and coupling of the diodes D1, D2, as described in detail below with reference to Figures 16-21.

The intermediate substrate contact portion 95 extends parallel to the first and the second intermediate conduction contact portions 90A, 90B, on a longitudinal side thereof and overlying the first or the second lower conduction contact portion 51C, 51D to which it is selectively connected, depending on the connection configuration of the diodes D1, D2, as shown in detail for example in Figures 16-22.

The intermediate substrate contact portion 95 also extends above the contact metal portions 80, 81 to which it is electrically connected through vias shown in Figures 14 and 15.

Figure 12C shows an example layout of the third interconnection metallization level 72.

In detail, in Figure 12C, the third interconnection metallization level 72 forms:
a plurality of first upper conduction contact portions 100A, each first upper conduction contact portion 100A overlying a respective first intermediate conduction contact portion 90A and in electrical contact therewith through vias not shown;
a plurality of second upper conduction contact portions 100B, each second upper conduction contact portion 100B overlying a respective second intermediate conduction contact portion 90B and in electrical contact therewith through vias not shown;
a third upper conduction contact portion 101, coupled to the third intermediate conduction contact portion 91 through vias not shown;
a fourth upper conduction contact portion 102, coupled to the fourth intermediate conduction contact portion 92 through vias not shown;
a first upper gate contact portion 103, coupled to the first intermediate gate contact portion 93 through vias not shown;
a second upper gate contact portion 104, coupled to the second intermediate gate contact portion 94 through vias not shown; and
an upper substrate contact portion 105, coupled to the intermediate substrate contact portion 95, as shown in Figure 14 and described in detail below.

Figure 12C also shows pads formed directly by the third interconnection metallization level 72 or thereabove and including the gate pads 59, 60, in direct electrical contact with the first and the second upper gate contact portions 103, 104, respectively; the conduction pads 57, 58, in direct electrical contact with the third and the fourth upper conduction contact portions 101, 102, respectively; and the substrate pad 61 in direct electrical contact with the upper substrate contact connection 104.

Figure 13 shows a possible embodiment of resistors R, R1, R2 that exploits the presence of the third semiconductor layer 45, of p-GaN, which forms for example the gate conductive regions 45A-45C of Figure 11. In fact, the third semiconductor layer 45 allows the 2-dimensional electron gas, 2deg, that forms in the underlying layer (third sub-layer 43.3, a channel sub-layer) to be partially depleted and therefore the resistivity of this zone to be increased.

In Figure 13, a depleting region 110, of p-GaN, is superimposed on a body 111 comprising a substrate 112, for example of silicon possibly covered by one or more layers of GaN, a channel layer 113, for example of a GaN alloy, and a barrier layer 114, of AlGaN.

For example, the substrate 112 may comprise the substrate 42, the first and the second sub-layers 43.1 and 43.2 of Figure 11; the channel layer 113 may comprise the third sub-layer 43.3, of Figure 11; and the barrier layer 114 may comprise the second semiconductor layer 44 of Figure 11.

As indicated, the depleting region 110 is superimposed on the barrier layer 114 and is arranged between a first and a second ohmic contact 115, 116. For example, the first and the second ohmic contacts 115, 116 may be formed in a similar way and in the same layer as the ohmic contact regions 50A-50D of Figure 11.

An insulating layer 118 covers here the depleting region 110.

The presence of the depleting layer 110 causes an increase in the resistivity of the portion of the channel layer 113 between the two ohmic contacts 115, 116, forming a resistor R/R1/R2 in the channel layer 113 (resistive portion 119). In this manner, resistors having a reduced length, integrated directly in the die 40 may be obtained.

Figures 14 and 15 show an implementation of the resistors R, R1, R2 in the die 40 using the solution of Figure 13 and the three interconnection metallization levels 70-72 shown in Figures 12A-12C.

In particular, here, the insulating layer that separates the first interconnection metallization level 70 from the second interconnection metallization level 71 is indicated as first insulating layer 54A and the insulating layer that separates the second interconnection metallization level 71 from the third interconnection metallization level 72 is indicated as second insulating layer 54B.

In particular, each resistor R/R1/R2 extends between a fifth and a sixth ohmic contact region 50E, 50F formed in the same layer as the ohmic contact regions 50A-50D of Figure 11, on and in direct electrical contact with the first semiconductor layer 43 of the semiconductor body 41 (and more precisely with the third sub-layer 43.3, a channel sub-layer) .

The fifth and the sixth ohmic contact regions 50E, 50F are each contacted by a respective contact metal portion 80, 81, formed in the first interconnection metallization level (Figure 12A).

The contact metal portions 80, 81 (forming a first contact metal portion 80 and a second contact metal portion 81) are coupled to the intermediate substrate contact portion 95, respectively to a further intermediate contact portion 96 (both belonging to the second interconnection metallization level 71) through substrate vias 97, of metal, extending in the first insulating layer 54A.

In practice, the fifth ohmic contact region 50E, the first contact metal portion 80 and the respective substrate via 97 form a lower substrate intermetal connection 120 that electrically couples a first end of the resistors R/R1/R2 to the intermediate substrate contact portion 95 and to the semiconductor body 41.

The sixth ohmic contact region 50F, the second contact metal portion 81 and the respective substrate via 97 form a resistor connection 121 that couples a second end of the resistors R/R1/R2 to the component(s) of the device 930 of Figure 11 depending on the topology of the substrate-biasing network 35, 635, 735, 835. For example, in case of the substrate-biasing network 735, 835 of Figures 7, 8, the further intermediate contact portion 96 may be the third intermediate conduction contact portion 91 of Figure 12B, to couple the second end of the first resistor R1 to the first conduction terminal S1.

In case of the substrate-biasing network 735, 835 of Figures 7, 8, a structure entirely similar to that of Figure 14 is provided for the second resistor R2. In this case, the further intermediate contact portion 96 is formed by the fourth intermediate conduction contact portion 92 of Figure 12B.

In case of the substrate-biasing network 35 of Figure 4, with connection of the second terminal of the resistor R to the common node D, the further intermediate contact portion 96 of Figure 14 may be coupled to a portion (not shown) of the first interconnection metallization level 70 connected through ohmic contact to the third sub-layer 43.3, between the first and the second ohmic contact regions 50A, 50B of Figure 11 (in a manner not shown).

In case of the substrate-biasing network 635 of Figure 6, the further intermediate contact portion 96 of Figure 14 may be coupled to the first lower gate contact portion 74 (for the first resistor R1) and to the second lower gate contact portion 75 (for the second resistor R2) of Figure 12A, in a manner not shown and obvious to the person skilled in the art.

Figure 14 also shows an upper substrate intermetal connection 122, formed by a plurality of metal vias extending through the second insulating layer 54B between the second and the third interconnection metallization levels 71, 72 and electrically coupling the intermediate substrate contact portion 95 in the second interconnection metallization level 71 (Figure 12B) to the upper substrate contact portion 105 in the third interconnection metallization level 72 (Figure 12C).

In practice, the lower substrate intermetal connection 120, the intermediate substrate contact portion 95, the upper substrate intermetal connection 122 and the upper substrate contact portion 105 implement the contact of the upper substrate contact portion 105 (and therefore of the substrate pad 61 not visible here) to the first semiconductor layer 43 and therefore to the substrate 42.

A further upper intermetal connection 123, formed by a plurality of metal vias extending through the second insulating layer 54B between the second and the third interconnection metallization levels 71, 72, electrically couple the further intermediate contact portion 96 to a further upper contact portion 124 formed in the third interconnection metallization level 72.

For example, in case of the substrate-biasing network 735, 835 of Figures 7, 8, the further upper contact portion 124 is the third upper conduction contact portion 101.

In practice, in this case, the further upper intermetal connection 123 electrically couples the third intermediate conduction contact portion 91 and the third upper conduction contact portion 101 of Figures 12B, 12C.

Further contact portions may also extend directly between such portions 91, 101, on the long side of the die 40.

Furthermore, similar connections using suitable vias between the first lower conduction contact portions 51A of Figure 12A, the third intermediate conduction contact portions 91A and the third upper conduction contact portions 101A allow the electrical connection between the third sub-layer 43.3 (at the first ohmic contact regions 50A, Figure 11) and the first source pad 57.

Similarly, the second lower conduction contact portions 51B of Figure 12A may be connected to the second source pad 58, as shown for example in Figures 16 and 20.

A passivation layer 125 (e.g. formed by a plurality of superimposed insulating layers) extends above the third interconnection metallization level 72 and is open at the pads 57-61, in a known manner.

Figures 16-19 show an embodiment of the device 730 of Figure 7.

In particular, Figure 16 shows a cross-section similar to Figure 11, wherein the portion of the first power element 31A is not shown but the portions of the second and the third interconnection metallization levels 71, 72 of the second power element 32A and the diode D1 are visible.

For clarity of illustration, in Figures 16-19 the same reference numbers as in Figures 11-15 have been used and the common parts are not described again.

In detail, Figure 16 shows a first anode interconnection 128 (formed by vias extending through the insulating layer 54) that couples the lower anode contact region 56D to the intermediate substrate contact portion 95 and the upper substrate intermetal connection 122 connects the intermediate substrate contact portion 95 to the upper substrate contact portion 105 (see also Figure 14), forming the connection of the anode of the diode D1 to the substrate node SUB of Figure 7.

Furthermore, Figure 16 shows a lower transistor source intermetal connection 230 (formed here by vias) that couples the second lower transistor source contact region 56B to the respective second intermediate conduction contact portion 90B, and an upper transistor source intermetal connection 231 (formed here by vias) that couples the second intermediate conduction contact portion 90B to the respective second upper conduction contact portion 100B, similarly and in parallel to the further upper intermetal connection 123 of Figure 14 in case of the device 730 of Figure 7.

As indicated above, here, the third gate conductive region 45C (gate region of the first diode D1) is electrically coupled to the third lower conduction contact portion 51C (source/cathode contact of the first diode D1) for connecting the first bias, diode-coupled transistor M1, to form the first diode D1, as shown in Figures 17 and 18 wherein, for clarity, the second and the third interconnection metallization levels 71, 72 and the interconnection structures have not been represented.

In detail, Figure 17 shows a portion of the die 40 in proximity to one end of a source finger of the first diode D1. The second semiconductor layer 44 is here interrupted at the third ohmic contact region 50C, in direct contact with the first semiconductor layer 43.

Figure 17 shows the shape of the third gate metallization region 49C that surrounds the third gate conductive region 45C and has an elongated portion 240 (see also Figure 18) also formed in the gate metallization level 49 and extending here beyond the second semiconductor layer 44.

The portion of the first insulating layer 54A that separates the gate metallization level 49 from the first interconnection metallization level 70 is removed above the elongated portion 240 of the third gate conductive region 45C, thus creating a direct electrical contact between the elongated portion 240 and the third metallization region 51C, as visible in Figure 18.

In this manner, with reference again to Figure 16, the third ohmic contact region 50C, a source contact for the first bias transistor M1, is short-circuited with the third gate conductive region 45C, the gate region of the first bias transistor M1, forming the diode D1.

Figure 19 shows, on a reduced scale and in a schematic manner, the interconnections of the diodes D1, D2 with the second interconnection metallization level 71.

In particular, Figure 19 shows, for each diode D1, D2, a first cathode interconnection 241 that connects each third metallization region 51C to the respective third intermediate conduction contact portion 91 as well as the first anode interconnection 128 that connects the fourth metallization region 51D of each diode D1, D2 to the intermediate substrate contact portion 95 of Figures 12B and 16.

Figures 20-22 show an embodiment of the device 830 of Figure 8; in particular, Figure 20 is similar and along the same cross-section as Figure 16, Figure 21 is similar to Figure 17 and Figure 22 is similar to Figure 18.

As is noted from the comparison of Figures 20-22 with analog figures 16-18, the structure of the device 830 of Figures 20-22 is entirely similar to that of the device 730 of Figures 16-19 and the only difference consists in that the connections of the third metallization region 51C and of the fourth metallization region 51D to the second interconnection metallization level 71 are exchanged.

Therefore, the parts of the device 830 of Figures 20-22 in common with the device 730 of Figures 16-19 will not be further described.

In detail, in Figures 20 and 21, the third metallization region 51C (source/cathode contact of the first diode D1) is coupled with the intermediate substrate contact portion 95 through a second cathode interconnection 245 formed by vias that extend between the first and the second interconnection metallization levels 70, 71, extending through the first insulating layer 54A. The upper substrate intermetal connection 122 in this case provides the coupling of the cathode terminal of the diode D1 to the substrate node SUB.

Figure 20 also shows a second anode interconnection 246 that couples the fourth metallization region 51D to the first intermediate conduction contact portion 91.

Alternatively, second anode interconnection 246 may be formed only on the end (not visible) of the fourth metallization region 51D and the intermediate substrate contact portion 95 may also extend on the fourth metallization region 51D, forming a field plate, similarly to what shown (but with opposite coupling) in Figure 16.

Figure 22 shows the connection between the third ohmic contact region 50C and the third gate conductive region 45C; the third ohmic contact region 50C, a source contact for the first bias transistor M1, is short-circuited with the third gate conductive region 45C. As is noted, this connection is exactly the same as in Figure 18 and will therefore not be further described.

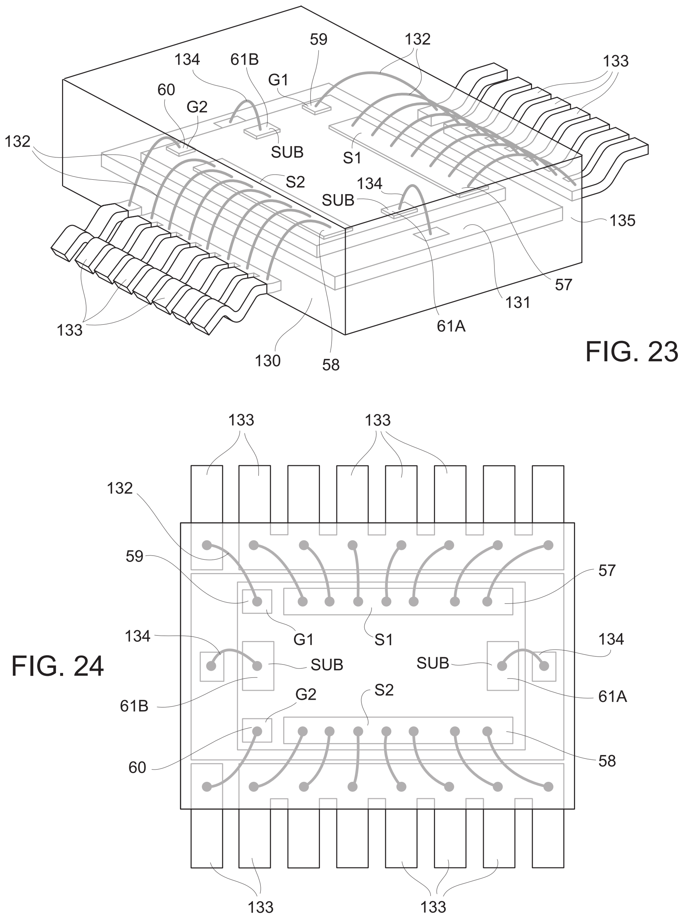

The bidirectional switch power device 30, 630, 730, 830, 930, 930' may be packaged in a TOLT (TOp-side-Leaded cooling package) type case, as shown in Figures 23 and 24.

In detail, the die 40 is attached to a leadframe 130 bonding the rear metallization layer 67 (Figure 11) to a support portion 131 of the leadframe 130; wires 132 couple the source and gate pads 57-60 to respective leads 133 of the leadframe 131.

In the embodiment shown, the die 40 has two substrate pads, indicated by 61A, 61B, coupled to the support portion 131 through respective wires 134.

An insulating housing 135, for example of resin, embeds the support portion 131, the die 40, the wires 132, 134 and the initial portion of the leads 133, in a manner known per se.

By virtue of the arrangement shown in Figures 23, 24, and with reference to Figure 11, the lower surface 41B of the semiconductor body 41 (and therefore the substrate 42) may be electrically connected to the upper surface 41A and therefore to the substrate node SUB.

In practice, in this manner, the substrate 42 is connected in a simple manner to the substrate terminal (SUB) 61 which, as discussed above, is maintained coupled, each time, to the lowest potential in the die 40.

Finally, it is clear that modifications and variations may be made to the bidirectional switch power device described and illustrated here without thereby departing from the scope of the present invention, as defined in the attached claims. For example, the different embodiments described may be combined to provide further solutions.

In addition, the electrical connection between the substrate terminals SUB and the substrate 42 may be implemented differently, through direct coupling, or by conductive vias traversing the semiconductor body 41.

Furthermore, the resistors may be formed differently, for example by suitable local doping of the channel layer 43.3 or without providing the depleting region 110 of Figure 9, with a suitable choice of the distance between the ohmic contacts 115, 116 exploiting the non-zero resistivity of the 2-dimensional gas. Alternatively, the resistors may be formed in the upper interconnection metal levels 71, 72 using high-resistivity materials (for example SiCr and TaN).

The ohmic contacts 50A-50F, 115, 116, may be formed in contact with the barrier layer 44, 114, or partially recessed in the barrier layer 44, 114 or even completely recessed therein, in direct contact with the channel layer 43.32, 112.

## Claims

1. An integrated bidirectional switch power device (30; 630; 730; 830; 930; 930') based on gallium nitride, comprising a die (40) including:
a semiconductor body (41) integrating a first and a second switch field effect transistor (31, 32), the semiconductor body comprising a semiconductor substrate (42) and a layer stack (43-45) superimposed on the substrate (42), the layer stack including a channel layer (43.3) of a channel semiconductor alloy of elements of groups III and V of the periodic table and a gate layer (45) of a gate semiconductor alloy including gallium nitride,
wherein the channel layer (43.3) forms a channel region (65) and the gate layer (45) forms a first and a second transistor gate region (45A, 45B) arranged at a mutual distance above the channel region, the substrate (42) electrically coupled to a substrate node (SUB, 61);
a first and a second conduction contact region (50A, 50B) of a first conductive material, arranged side by side and at a mutual distance on opposite sides of the channel region (65);
a substrate-biasing network (35; 635; 735; 835) configured to electrically couple the substrate node (SUB, 61) selectively to the first and the second conduction contact regions (50A, 50B) which is at a minimum potential,
the substrate-biasing network (35; 635; 735; 835) comprising a first and a second diode (D1, D2) coupled in anti-series and having each a first terminal and a second terminal, wherein the first terminal of the first diode is coupled to the first conduction contact region (50A), the first terminal of the second diode is coupled to the second conduction contact region (50B) and the second terminals of the first and the second diodes are coupled together and to the substrate node (SUB),
wherein the first diode (D1) is formed by a field effect, diode-connected transistor (M1) and the second diode (D2) is formed by a second field effect, diode-connected transistor (M2),
the first and the second field effect, diode-connected transistors (M1, M2) have the same structure as the first and the second switch field effect transistors (31, 32), extend at the sides of the first and the second switch field effect transistors and comprise a respective first diode contact region (50C), a respective second diode contact region (50D) and a respective diode gate region (45C), wherein the first and the second diode contact regions (50C, 50D) are formed by the first conductive material and the diode gate regions (45C) are formed by the gate layer (45), and
the substrate-biasing network (35; 635; 735; 835) further comprises at least one first resistor (R, R1, R2) having a first resistor terminal coupled to the substrate node (SUB, 61) and a second resistor terminal coupled to a region chosen from among:
i) a portion of the channel region (65) arranged between the first and the second conduction contact regions 50A, 50B,
ii) the first transistor gate region (45A), and
iii) the first conduction contact region (50A), and
the first resistor (R, R1, R2) being formed by a resistive portion of the channel layer (43.3), laterally to the channel region (65).

2. The device according to claim 1, wherein the resistive portion (119) is overlaid by a depleting region (110) formed by the gate layer (45).

3. The device according to claim 1 or 2, wherein the resistive portion (119) has one end ohmically coupled with the substrate (42) and to the substrate node (SUB, 61).

4. The device according to any of the preceding claims, wherein the first resistor (R1) is coupled to the first transistor gate region (45A), the device further comprises a second resistor (R2) coupled to the second transistor gate region (45B), the second resistor (R2) formed by a further resistive portion of the channel layer (43.3), laterally to the channel region (65), the further resistive portion (119) having one end ohmically coupled with the substrate (42) and to the substrate node (SUB, 61).

5. The device according to any of claims 1-3, wherein the first resistor (R1) is coupled to the first conduction contact region (50A), the device further comprises a second resistor (R2) coupled to the second conduction contact region (50B), the second resistor (R2) formed by a further resistive portion of the channel layer (43.3), laterally to the channel region (65), the further resistive portion (119) having one end ohmically coupled with the substrate (42) and to the substrate node (SUB, 61).

6. The device according to any of the preceding claims, wherein the channel semiconductor alloy comprises gallium nitride of a first conductivity type and the gate semiconductor alloy is of a second conductivity type.

7. The device according to any of the preceding claims, comprising at least one first interconnection metal layer (70) overlying the semiconductor body (41) and forming:
a first lower conduction contact portion (51A) in electrical contact with the first conduction contact region (50A);
a second lower conduction contact portion (51B) in electrical contact with the second conduction contact region (50B);
a third and a fourth lower conduction contact portion (51C, 51D) for each diode (D1, D2), the third lower conduction contact portion (51C) of each diode being in direct electrical contact with the respective first diode contact region (50C) and the fourth lower conduction contact portion (51D) of each diode being in direct electrical contact with the respective second diode contact region (50D),
the device further comprising, for each diode, a diode gate metallization region (49C, 140) underlying the first interconnection metal layer (70) and in direct electrical contact with the respective diode gate region (45C) and with the respective third metallization region (51C).

8. The device according to preceding claim, wherein the first, the second, and the third lower conduction contact portions (51A, 51B, 51C) form field plates.

9. The device according to claim 7 or 8, further comprising a gate metallization layer (49) forming the diode gate metallization region (49C, 140) as well as a first and a second transistor gate metallization region (49A, 49B); the first and the second transistor gate metallization regions (49A, 49B) arranged above and in direct electrical contact with the first, respectively the second transistor gate region (45A, 45B); and the first and the second transistor gate metallization regions (49A, 49B) coupled to a first and respectively a second lower gate metal connection portion (74, 75) formed by the first interconnection metal layer (70).

10. The device according to any of claims 7-9, further comprising a second interconnection metal layer (71) overlying the first interconnection metal layer (70) and separated therefrom by a first insulating layer (54A); the second interconnection metal layer (71) forming:
a first and respectively a second intermediate conduction contact portion (90A, 91, 90B, 92) partially overlying and electrically coupled to the first, respectively the second lower conduction contact portion (51A, 51B) through lower conduction intermetal connections (230);
a first and a second intermediate gate contact portion (93, 94) overlying and electrically coupled to the first and respectively the second lower gate metal connection portion (74, 75) through lower gate intermetal connections; and
an intermediate substrate contact portion (95) overlying and electrically and selectively coupled to the third or the fourth conduction metallization regions (51C, 51D), the intermediate substrate contact portion (95) further ohmically coupled with the substrate (42) and electrically connected with the substrate node (SUB, 61).

11. The device according to the preceding claim, further comprising a third interconnection metal layer (72) overlying the second interconnection metal layer (71) and separated therefrom by a second insulating layer (54B); the third interconnection metal layer (72) forming:
a first and respectively a second upper gate contact portion (103, 104) overlying and electrically coupled to the first and respectively the second lower gate metal connection portion (74, 75) through upper gate intermetal connections;
a first and respectively a second upper conduction contact portion (101, 102) overlying and electrically coupled to the first and respectively the second intermediate conduction contact portion (90A, 91, 90B, 92) through respective upper conduction intermetal connections (231); and
an upper substrate contact portion (105) overlying and electrically coupled to the intermediate substrate contact portion (95) through upper substrate intermetal connections (122), the upper substrate contact portion (105) forming the substrate node (SUB).

12. The device according to any of the preceding claims, wherein the layer stack (43-45) further comprises a first sub-layer (43.1), superimposed on the substrate (42) and including a first GaN alloy; a buffer layer (43.2) superimposed on the first sub-layer (43.1) and underlying the channel layer (43.3) and including a second GaN alloy; and a barrier layer (44) superimposed on the channel layer (43.3) and including aluminum gallium nitride, wherein the channel semiconductor alloy is a third GaN alloy, and the barrier layer (44) forms a heterostructure with the channel layer (43.3); wherein the first transistor gate region (45A), the second transistor gate region (45B) and the diode gate region (45C) of each diode (D1, D2) are arranged above the barrier layer (44) and comprise a fourth GaN alloy opposite conductivity to the channel layer (43_3) and the barrier layer (44).

13. The device according to any of the preceding claims, wherein the substrate (42) of the semiconductor body (41) is bonded to a support portion (131) of a leadframe (130) and a connection wire (134) couples the substrate node (SUB, 61) to the support portion of the leadframe (130).

14. The device according to the preceding claim, wherein the die (40) and the leadframe (130) are packaged in an electrically insulating case (135) and form a TOLT - TOpside-Leaded cooling - package.
